# EUROPÄISCHE PATENTSCHRIFT

(11) **EP 2 718 557 B1**
(45) Veröffentlichungstag und Bekanntmachung des Hinweises auf die Patenterteilung: **17.12.2014**
(21) Anmeldenummer: 12728167.3
(22) Anmeldetag: 31.05.2012
(51) Int. Cl.: F02D 41/20, F02D 19/02, G01M 15/04, F02M 21/02

(54) **ENDLAGEÜBERWACHUNG EINES GASEINBLASEVENTILS**
END-POSITION-MONITORING OF A GAS INJECTOR
SURVEILLANCE DE LA POSITION DE FIN DE COURSE D'UNE SOUPAPE D'INJECTION DE GAZ

(30) Priorität: 07.06.2011 AT 8412011
(43) Veröffentlichungstag der Anmeldung: 16.04.2014
(73) Patentinhaber: GE Jenbacher GmbH & Co OHG, 6200 Jenbach (AT)
(72) Erfinder: FRÖHLICH, Moritz, 6020 Innsbruck (AT); KRAUS, Markus, A-6210 Wiesing (AT); KRÖLL, Markus, A-6295 Ginzling (AT)
(74) Vertreter: Gangl, Markus
(86) Internationale Anmeldenummer: PCT/AT2012/000152
(87) Internationale Veröffentlichungsnummer: WO 2012/167290

(56) Entgegenhaltungen:
- DE-A1- 10 215 906
- DE-A1- 10 335 152
- DE-A1-102008 029 224
- US-A- 3 202 839

## Beschreibung

Die vorliegende Erfindung beschäftigt sich mit einem Verfahren zur Überprüfung des Vorliegens einer korrekten Endlage eines in einer Brennkraftmaschine zwischen einer Kraftstoffquelle und einem Brennraum angeordneten, elektromagnetisch betätigten Gaseinblaseventils.

Außerdem bezieht sich die Erfindung auf eine Brennkraftmaschine mit einer Motorsteuerung, einer Quelle für gasförmigen Kraftstoff, wenigstens einem Brennraum, in welchem der gasförmige Kraftstoff gezündet wird und einem zwischen der Quelle für den gasförmigen Kraftstoff und dem wenigstens einen Brennraum angeordneten, elektromagnetisch betätigten Gaseinblaseventil.

Elektromagnetisch betätigte Gaseinblaseventile sind durch Anlegen einer entsprechenden elektrischen Öffnungsspannung aus einer geschlossenen Endlage, in welcher sie die Verbindung zwischen der Kraftstoffquelle und dem Brennraum unterbrechen, in eine geöffnete Endlage bewegbar.

Wird das Gaseinblaseventil durch einen Defekt oder aufgrund eines Fremdkörpers nicht komplett geschlossen, kann gasförmiger Kraftstoff (im folgenden kurz als "Gas" bezeichnet) zu einem ungewünschten Zeitpunkt und/oder in einer ungewünschten Menge durch das Gaseinblaseventil strömen. Durch das in den Brennraum strömende Gas und der dortigen Vermischung mit Luft kann sich zu einem dafür nicht vorgesehenen Zeitpunkt ein zündfähiges Gemisch bilden. Außerdem kann es zu einem niedrigeren Lambda-Wert des Gemisches im Brennraum als gewünscht kommen (zu fettes Gemisch), da mehr Gas als gewollt in den Brennraum strömt. In beiden Fällen kann eine Beschädigung Brennkraftmaschine durch eine ungewollte bzw. unkontrollierte Verbrennung auftreten.

Es sind bereits verschiedene Verfahren bekannt geworden, die detektieren, ob sich das Gaseinblaseventil in seiner geöffneten Endlage befindet. Wenn sich das Gaseinblaseventil zum Überprüfungszeitpunkt in seiner geöffneten Endlage befindet, obwohl es zu diesem Zeitpunkt planmäßig geschlossen sein sollte, kann so auf das Vorliegen eines defekten Gaseinblaseventils geschlossen werden.

DE10215906 offenbart ein Verfahren und eine Vorrichtung zur Überwachung mindestens eines Versorgungsventils zur Kraftstoffversorgung eines Verbrennungsmotors auf eine Fehlfunktion und/oder Beschädigung bzw. Undichtigkeit. Nachteilig bei solchen Verfahren ist, dass zwischen dem Auftreten der fehlerhaften Ventilstellung und der Detektion dieses Zustands mindestens ein Verbrennungszyklus erfolgt. Durch diesen einen Verbrennungszyklus kann bereits eine Beschädigung des Motors erfolgen.

Aufgabe der Erfindung ist es, ein verbessertes Verfahren zur Detektion eines ungewollten Öffnungszustandes des Gaseinblaseventils bereitzustellen.

Diese Aufgabe wird durch ein Verfahren mit den Merkmalen des Anspruchs 1 und eine Brennkraftmaschine mit den Merkmalen des Anspruchs 11 gelöst. Weitere vorteilhafte Ausführungsformen der Erfindung sind in den abhängigen Ansprüchen definiert.

Bei der Erfindung ist also im Gegensatz zum Stand der Technik nicht die Überprüfung der geöffneten Endlage sondern die Überprüfung der geschlossenen Endlage des Gaseinblaseventils vorgesehen.

Die Überprüfung des Vorliegens der geschlossenen Endlage beinhaltet ein Beaufschlagen des Gaseinblaseventils mit einer elektrischen Testspannung und eine Messung des durch die elektrische Testspannung verursachten Entladungsstroms. Dies erfolgt zu einem beliebigen Zeitpunkt an dem das Gaseinblaseventil geschlossen sein sollte, vorzugweise jedoch in der Zeitspanne zwischen dem vorgegebenen Ventilschließzeitpunkt und dem geplanten Zündzeitpunkt.

Bei elektromagnetisch betätigten Gaseinblaseventilen ist zum Öffnen und Schließen des Gaseinblaseventils ein bewegbar in einer Magnetspule gelagerter Eisenkern vorgesehen. Durch die Bewegung des Eisenkerns beim Öffnen und Schließen des Gaseinblaseventils ändert sich die Induktivität der Magnetspule. Hierdurch ändert sich der Verlauf des durch die elektrische Testspannung erzeugten Entladungsstromes. Die Erfindung macht sich also, dass die Induktivität der Magnetspule von der Position des Eisenkerns in der Spule abhängt, wobei der Eisenkern umso weiter aus der Spule heraussteht, je weiter das Gaseinblaseventil von seiner geschlossenen Endlage entfernt ist.

Die vorliegende Erfindung beschäftigt sich mit einem Verfahren zur Überprüfung des Vorliegens einer korrekten Endlage eines in einer Brennkraftmaschine zwischen einer Kraftstoffquelle und einem Brennraum angeordneten, elektromagnetisch betätigten Gaseinblaseventils.

Außerdem bezieht sich die Erfindung auf eine Brennkraftmaschine mit einer Motorsteuerung, einer Quelle für gasförmigen Kraftstoff, wenigstens einem Brennraum, in welchem der gasförmige Kraftstoff gezündet wird und einem zwischen der Quelle für den gasförmigen Kraftstoff und dem wenigstens einen Brennraum angeordneten, elektromagnetisch betätigten Gaseinblaseventil.

Elektromagnetisch betätigte Gaseinblaseventile sind durch Anlegen einer entsprechenden elektrischen Öffnungsspannung und dem dadurch fließenden Öffnungsstrom aus einer geschlossenen Endlage, in welcher sie die Verbindung zwischen der Kraftstoffquelle und dem Brennraum unterbrechen, in eine geöffnete Endlage bewegbar. Die Rückführung der Gaseinblaseventile in die geschlossene Endstellung erfolgt vorzugsweise mechanisch durch eine Feder im Ventil.

Wird das Gaseinblaseventil durch einen Defekt oder aufgrund eines Fremdkörpers nicht komplett geschlossen, kann gasförmiger Kraftstoff (im folgenden kurz als "Gas" bezeichnet) zu einem ungewünschten Zeitpunkt und/oder in einer ungewünschten Menge durch das Gaseinblaseventil strömen. Durch das in den Brennraum strömende Gas und der dortigen Vermischung mit Luft kann sich zu einem dafür nicht vorgesehenen Zeitpunkt ein zündfähiges Gemisch bilden. Außerdem kann es zu einem niedrigeren Lambda-Wert des Gemisches im Brennraum als gewünscht kommen (zu fettes Gemisch), da mehr Gas als gewollt in den Brennraum strömt. In beiden Fällen kann eine Beschädigung der Brennkraftmaschine durch eine ungewollte bzw. unkontrollierte Verbrennung auftreten.

Es sind bereits verschiedene Verfahren bekannt geworden, die detektieren, ob sich das Gaseinblaseventil in seiner geöffneten Endlage befindet. Wenn sich das Gaseinblaseventil zum Überprüfungszeitpunkt in seiner geöffneten Endlage befindet, obwohl es zu diesem Zeitpunkt planmäßig geschlossen sein sollte, kann so auf das Vorliegen eines defekten Gaseinblaseventils geschlossen werden.

Nachteilig bei solchen Verfahren ist, dass zwischen dem Auftreten der fehlerhaften Ventilstellung und der Detektion dieses Zustands mindestens ein Verbrennungszyklus erfolgt. Durch diesen einen Verbrennungszyklus kann bereits eine Beschädigung des Motors erfolgen.

Aufgabe der Erfindung ist es, ein verbessertes Verfahren zur Detektion eines ungewollten Öffnungszustandes des Gaseinblaseventils bereitzustellen.

Diese Aufgabe wird durch ein Verfahren mit den Merkmalen des Anspruchs 1 und eine Brennkraftmaschine mit den Merkmalen des Anspruchs 11 gelöst. Weitere vorteilhafte Ausführungsformen der Erfindung sind in den abhängigen Ansprüchen definiert.

Bei der Erfindung ist also im Gegensatz zum Stand der Technik nicht die Überprüfung der geöffneten Endlage sondern die Überprüfung der geschlossenen Endlage des Gaseinblaseventils vorgesehen.

Die Überprüfung des Vorliegens der geschlossenen Endlage beinhaltet ein Beaufschlagen des Gaseinblaseventils mit einer elektrischen Testspannung, die einen Teststrom zur Folge hat. Nach dem Abschalten der Testspannung erfolgt eine Messung des auftretenden Entladungsstroms.

Dies erfolgt zu einem beliebigen Zeitpunkt an dem das Gaseinblaseventil geschlossen sein sollte, vorzugweise jedoch in der Zeitspanne zwischen dem vorgegebenen Ventilschließzeitpunkt und dem geplanten Zündzeitpunkt.

Bei elektromagnetisch betätigten Gaseinblaseventilen ist zum Öffnen und Schließen des Gaseinblaseventils ein bewegbar in einer Magnetspule gelagerter Eisenkern vorgesehen. Durch die Bewegung des Eisenkerns und die dadurch erfolgte Veränderung des Luftspalts im Magnetkreis beim Öffnen und Schließen des Gaseinblaseventils ändert sich die Induktivität der Magnetspule. Hierdurch ändert sich der Verlauf des durch die elektrische Testspannung erzeugten Entladungsstromes. Die Erfindung macht sich also zu Nutze, dass die Induktivität der Magnetspule von der Position des Eisenkerns in der Spule abhängt, wobei der Eisenkern umso weiter aus der Spule heraussteht, je weiter das Gaseinblaseventil von seiner geschlossenen Endlage entfernt ist.

Der durch die elektrische Testspannung beaufschlagte Teststrom kann bevorzugt so gewählt werden, dass die zugeführte elektrische Energie nicht für ein Abheben des Gaseinblaseventils vom Ventilsitz ausreicht. Es ist daher eine Überprüfung zu einem Zeitpunkt möglich, an welchem sich das Gaseinblasenventil planmäßig durch die mechanische Federkraft in seiner geschlossenen Endlage befinden (und dort auch bleiben) sollte. Dies hat den Vorteil, dass direkt auf eine fehlerhafte Ventilstellung geschlossen werden kann, und zwar noch bevor es zu einer geplanten Zündung im Brennraum kommt. Es kann daher bereits vor dem Entzünden des Gemisches im Brennraum auf eine falsche Ventilstellung reagiert und der Zündfunke unterdrückt werden, sodass keine unkontrollierte Verbrennung stattfindet.

Auf den gemessenen Verlauf des Entladungsstromes können in der Motorsteuerung der Brennkraftmaschine verschiedene mathematische Techniken angewandt werden (die dem Fachmann allesamt bekannt sind), um einen Messwert für die Ventilstellung zu erhalten, zum Beispiel:
- Ermittlung der Steigung des Entladungsstromes
- Messung des absoluten Stromwerts zu einem bestimmten Zeitpunkt
- Ermittlung des Integrals der Kurve des Entladungsstromes
- Berechnung der Induktivität bzw. des Scheinwiderstands aus dem zeitlichen Stromverlauf nach dem Zusammenhang I(t)=Imax*exp(-R*t/L)

Diese mathematischen Techniken können auf den Bereich mit steigendem Ladestrom und/oder auf den Bereich mit fallendem Entladungsstrom angewandt werden.

Die Erfindung gestattet es auch, zwischen defekten und verschlissenen Gaseinblaseventilen zu unterscheiden, nämlich dadurch, dass die Beaufschlagung mit der elektrischen Testspannung wenigstens zweimal durchgeführt wird, was die Bestimmung des Zeitpunkts des und/oder der benötigten Zeit bis zum Erreichen(s) der geschlossenen Endlage des Gaseinblaseventils gestattet.

Der Verschleiß der eingesetzten Gaseinblaseventile charakterisiert sich durch eine Verschiebung des Zeitpunkts, zu welchem die geschlossene Endlage erreicht wird. Durch eine erste Messung unmittelbar nach dem Schließzeitpunkt eines neuwertigen Magnetventils und beliebig vielen, aber wenigstens einer weiteren Messung(en) (nach definierten Zeitspannen verzögert zur ersten Messung) kann der zeitliche Ablauf des Schließvorgangs festgestellt werden. Basierend auf diesen Messungen kann der tatsächliche Schließzeitpunkt ermittelt werden. Durch diesen Schließzeitpunkt kann der Gasmengenstrom durch das Ventil ermittelt werden und dieser in die Regelung einfließen bzw. bei einer zu großen Gasmenge eine Beschädigung der Brennkraftmaschine verhindert werden.

Der Vorteil einer wiederholten Messung besteht also in der Ermittlung des Zeitpunkts, zu welchem die geschlossene Endlage erreicht wird (im Gegensatz zum Detektieren, dass die geschlossene Endlage überhaupt erreicht wurde, im Falle der einmaligen Messung). Dadurch kann ein gefährlicher Zustand exakter ermittelt werden und die Brennkraftmaschine länger mit verschlissenen Ventilen betrieben werden und somit die Verfügbarkeit der Brennkraftmaschinen erhöht werden.

Die Erfindung ist besonders bevorzugt bei solchen Brennkraftmaschinen vorgesehen, die als stationäre Otto-Gas-Motoren, insbesondere zur Stromerzeugung, ausgebildet sind.

Weitere Vorteile und Einzelheiten der Erfindung ergeben sich anhand der Figuren sowie der dazu gehörigen Beschreibung. Dabei zeigen:
- Fig. 1: schematisch den Aufbau eines elektromagnetisch betätigten Gaseinblaseventils,
- Fig. 2: Verläufe des Entladungsstromes über die Zeit für unterschiedliche Ventilstellungen,
- Fig. 3: Ergebnisse verschiedener Auswertemethoden und
- Fig. 4: eine Darstellung der Detektion von unterschiedlichen Schließzeitpunkten des Gaseinblaseventils.

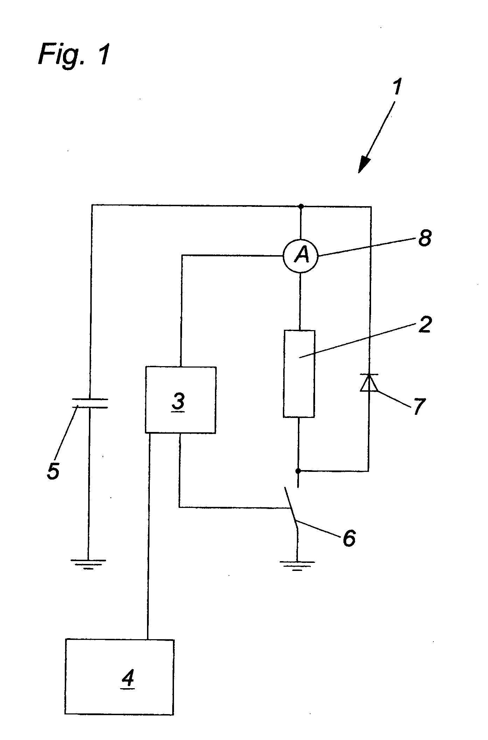

Fig. 1 zeigt schematisch das elektrische Ersatzschaltbild eines elektromagnetisch betätigten Gaseinblaseventils 1. Die Anordnung von Spule, Eisenkern und damit verbundenen Ventilkopf ist insgesamt mit dem Bezugszeichen 2 bezeichnet und entspricht vollständig dem Stand der Technik. Das Bezugszeichen 5 bezeichnet einen Kondensator zur Spannungsversorgung. Bevorzugt ist nur für das Öffnen des Gaseinblaseventils 1 das Anlegen einer elektrischen Spannung erforderlich. Das Schließen kann durch einen mechanischen Kraftspeicher (Feder) erfolgen.

Ein Controller 3 des Gaseinblaseventils 1 steht mit einer Motorsteuerung 4 der Brennkraftmaschine in Verbindung, die so ausgebildet ist, dass sie zu wenigstens einem Zeitpunkt, an welchem sich das Gaseinblaseventil in einer geschlossenen Endlage befinden sollte, durch den Controller 3 über den Schalter 6 eine elektrische Testspannung an das Gaseinblaseventil 1 anlegt, den durch die elektrische Testspannung verursachten Entladungsstrom I misst und so auf das Vorliegen der geschlossenen Endlage des Gaseinblaseventils 1 rückschließt. Zur Messung des über die Freilaufdiode 7 verlaufenden Entladungsstromes I ist ein Amperemeter 8 vorgesehen, dessen Signale dem Controller 3 zuführbar sind.

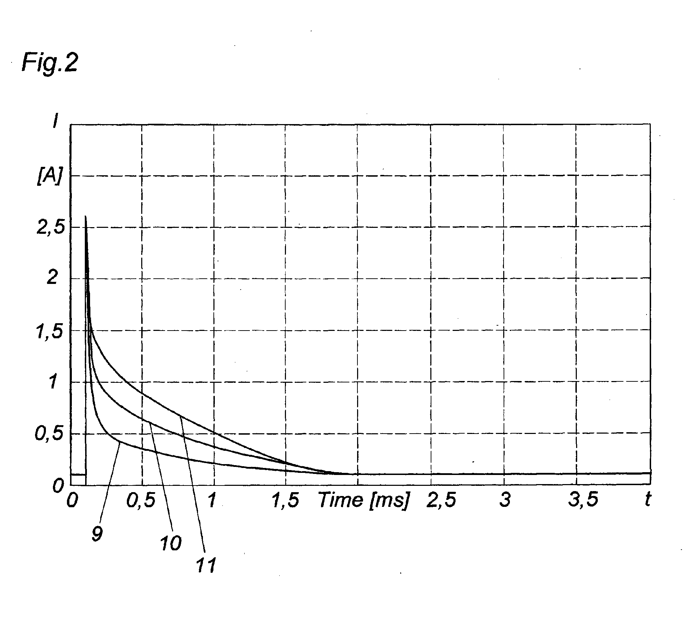

Fig. 2 stellt den in Reaktion auf eine angelegte Testspannung gemessenen Entladungsstrom I (in Ampere), aufgetragen über die Zeit t (in Millisekunden) dar.

Die Kurve 9 stellt das Messergebnis für den Fall dar, dass das Gaseinblaseventil 1 während der Messung vollständig geöffnet war (100 % Verfahrweg des Eisenkerns).

Die Kurve 11 stellt das Messergebnis für den Fall dar, dass das Gaseinblaseventil 1 während der Messung vollständig geschlossen war (0 % Verfahrweg des Eisenkerns).

Die Kurve 10 stellt das Messergebnis für den Fall dar, dass das Gaseinblaseventil 1 während der Messung ungefähr halb geöffnet war (60 % Verfahrweg des Eisenkerns).

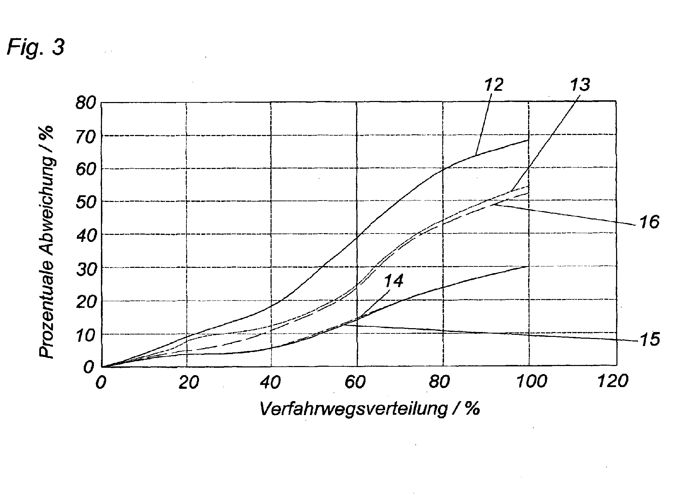

Fig. 3 stellt eine Gegenüberstellung der Ergebnisse verschiedener Auswertemethoden dar.

Auf der y-Achse ist die prozentuale Abweichung vom Messwert eines komplett geschlossenen Ventils dargestellt (Schnittpunkt der beiden Achsen). Auf der x-Achse ist der Verfahrweg des Eisenkerns in Prozent dargestellt, wobei 0% einem komplett geschlossenen und 100% einem komplett geöffneten Ventil entsprechen

Die Kurve 12 zeigt das Ergebnis einer Steigungsberechnung basierend auf der Steigung des Entladungsstromes I.

Die Kurve 13 zeigt das Ergebnis einer Berechnung auf Basis der maximalen Amplitude des Entladungsstromes I zu einem festgelegten Zeitpunkt im Verlauf des Entladungsstrom.

Die Kurve 14 zeigt das Ergebnis einer Berechnung basierend auf einer Integration der Fläche unterhalb des Verlaufes des Entladungsstromes I in Fig. 2 über die gesamte Entladedauer.

Die Kurve 15 zeigt das Ergebnis einer Induktivitätsberechnung aus dem zeitlichen Stromverlauf nach dem Zusammenhang I(t)=Imax*exp(-R*t/L)

Die Kurve 16 zeigt das Ergebnis einer Berechnung basierend auf einer Integration der Fläche unterhalb des Verlaufes des Entladungsstromes I in Fig. 2 über einen definierten zeitlichen Teilbereich der gesamten Entladedauer

Aus allen Methoden kann basierend auf der Auswertung des zeitlichen Entladestromverlaufs eindeutig die Position des Ventils (geschlossen, geöffnet oder teilweise geöffnet) detektiert werden, wobei sich die Güte der Erkennung unterscheidet. Die Kurve 12 zeigt die beste Detektierbarkeit, die Kurven 14 und 15 die schlechteste, aber immer noch ausreichende Detektierbarkeit.

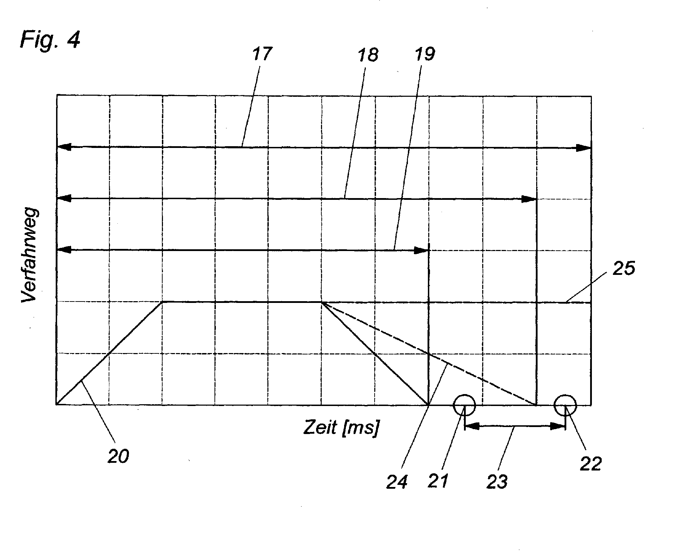

Die Fig. 4 bezieht sich auf die Möglichkeit, durch wenigstens zweimalige Anwendung des erfindungsgemäßen Verfahrens zwischen einem defekten und einem nur verschlissenen Gaseinblaseventil 1 unterscheiden zu können. Fig. 4 zeigt auf der y-Achse den Verfahrweg des Eisenkerns. Auf der x-Achse ist die Zeit t in Millisekunden aufgetragen.

Die Zeitspanne 17 zeigt die Öffnungsdauer eines defekten Gaseinblaseventils 1, welche an sich unendlich ist (hier begrenzt durch die Zeitdauer der Messung), da es ja nie die geschlossenen Endlage erreicht.

Die Zeitspanne 19 zeigt die Öffnungsdauer eines neuwertigen, einwandfrei funktionierenden Gaseinblaseventils 1.

Die Zeitspanne 18 zeigt die Öffnungsdauer eines verschlissenen Gaseinblaseventils 1.

Die Kurve 20 zeigt den Verfahrweg eines neuwertigen Gaseinblaseventils 1.

Die Kurve 25 zeigt den Verfahrwerg eines Gaseinblaseventils 1 mit einem nach dem Öffnen erfolgten Defekt.

Die Kurve 24 zeigt den Verfahrweg eines verschlissenen Gaseinblaseventils 1.

Die Bezugszeichen 21 und 22 bezeichnen die Zeitpunkte der ersten und zweiten erfindungsgemäßen Detektierung. Die Zeitspanne 23 ist die vorgegebene Verschleißtoleranz und beträgt hier 0,5 ms.

Zum Zeitpunkt 22 der zweiten Detektierung ist ein verschlissenes Ventil geschlossen, ein defektes Ventil jedoch weiterhin geöffnet. Somit kann bei einem verschlissenen Ventil die Öffnungsdauer durch die Motorsteuerung 4 auf die erforderliche Gasmenge eingestellt werden und die Brennkraftmaschine mit den neuen Einstellungen weiter betrieben werden. Bei einem defekten Ventil wird jedoch die Zündung deaktiviert und die Brennkraftmaschine abgestellt, um eine Beschädigung durch die überhöhte Gasmenge zu verhindern.

## Patentansprüche

1. Verfahren zur Überprüfung, ob sich ein in einer Brennkraftmaschine zwischen einer Kraftstoffquelle und einem Brennraum angeordnetes, elektromagnetisch betätigtes Gaseinblaseventil (1) in seiner geschlossenen Endlage befindet, beinhaltend ein Beaufschlagen des Gaseinblaseventils (1) mit einer elektrischen Testspannung und eine Messung des durch die elektrische Testspannung verursachten Entladungsstroms (I).

2. Verfahren nach Anspruch 1, wobei die elektrische Testspannung in der Zeitspanne zwischen einem vorgegebenen Ventilschließzeitpunkt und einem geplanten Zündzeitpunkt angelegt wird.

3. Verfahren nach Anspruch 1 oder 2, wobei die elektrische Testspannung in Form eines Gleichspannungspulses mit vorbestimmter Zeitdauer und/oder vorbestimmter Amplitude angelegt wird.

4. Verfahren nach Anspruch 1 oder 2, wobei die elektrische Testspannung in Form einer Wechselspannung mit vorbestimmter Zeitdauer und/oder vorbestimmter Amplitude angelegt wird.

5. Verfahren nach einem der Ansprüche 1 bis 4, wobei die Steigung des Entladungsstroms (I) in einem vorbestimmten Zeitintervall bestimmt wird.

6. Verfahren nach einem der Ansprüche 1 bis 4, wobei der absolute Wert des Entladungsstroms (I) zu wenigstens einem Zeitpunkt bestimmt wird.

7. Verfahren nach einem der Ansprüche 1 bis 4, wobei ein Integral des Entladungsstroms (I) über ein vorbestimmtes Zeitintervall bestimmt wird.

8. Verfahren nach einem der Ansprüche 1 bis 4, wobei aus dem Entladungsstrom die Induktivität oder der Scheinwiderstand der Ventilspule bestimmt wird.

9. Verfahren nach einem der Ansprüche 1 bis 8, wobei die Beaufschlagung mit der elektrischen Testspannung wenigstens zweimal durchgeführt wird, zur Bestimmung des Zeitpunkts des und/oder der benötigten Zeit bis zum Erreichen(s) der geschlossenen Endlage des Gaseinblaseventils (1).

10. Verfahren nach Anspruch 9, wobei durch eine Steuerung der Brennkraftmaschine in Abhängigkeit des bestimmten Zeitpunkts bzw. der benötigten Zeit zwischen einem verschlissenen und einem defekten Gaseinblaseventil (1) unterschieden wird und wobei durch die Steuerung bei einem verschlissenen Gaseinblaseventil (1) die Öffnungsdauer des Gaseinblaseventils (1) auf die erforderliche Gasmenge eingestellt und bei einem defekten Gaseinblaseventil die Zündung des Brennraumes deaktiviert wird.

11. Brennkraftmaschine mit einer Motorsteuerung (4), einer Quelle für gasförmigen Kraftstoff, wenigstens einem Brennraum, in welchem der gasförmige Kraftstoff gezündet wird und einem zwischen der Quelle für den gasförmigen Kraftstoff und dem wenigstens einen Brennraum angeordneten, elektromagnetisch betätigten Gaseinblaseventil (1), **dadurch gekennzeichnet, dass** die Motorsteuerung (4) zu wenigstens einem Zeitpunkt, an welchem sich das Gaseinblaseventil (1) in einer geschlossenen Endlage befinden sollte, eine elektrische Testspannung an das Gaseinblaseventil (1) anlegt, den durch die elektrische Testspannung verursachten Entladungsstrom (I) misst und so auf das Vorliegen der geschlossenen Endlage des Gaseinblaseventils (1) rückschließt.

## Claims

1. A method of checking whether an electromagnetically actuated gas injector (1) arranged in an internal combustion engine between a fuel source and a combustion chamber is in its closed end position, including applying an electric test voltage to the gas injector (1) and measuring the discharge current (I) caused by the electric test voltage.

2. A method as set forth in claim 1 wherein the electric test voltage is applied in the period of time between a predetermined injector valve closing time and a planned ignition time.

3. A method as set forth in claim 1 or claim 2 wherein the electric test voltage is applied in the form of a dc voltage pulse with a predetermined time duration and/or of predetermined amplitude.

4. A method as set forth in claim 1 or claim 2 wherein the electric test voltage is applied in the form of an ac voltage with a predetermined time duration and/or of predetermined amplitude.

5. A method as set forth in one of claims 1 through 4 wherein the increase in the discharge current (I) is determined in a predetermined time interval.

6. A method as set forth in one of claims 1 through 4 wherein the absolute value of the discharge current (I) is determined at at least one moment in time.

7. A method as set forth in one of claims 1 through 4 wherein an integral of the discharge current (I) is determined over a predetermined time interval.

8. A method as set forth in one of claims 1 through 4 wherein the inductance or the impedance of the injector valve coil is determined from the discharge current.

9. A method as set forth in one of claims 1 through 8 wherein the application of the electric test voltage is performed at least twice to determine the moment in time of the attainment of the closed end position of the gas injector (1) and/or the time required to reach the closed end position thereof.

10. A method as set forth in claim 9 wherein a distinction is drawn between a worn and a defective gas injector (1) by a control of the internal combustion engine in dependence on the determined moment in time or the required time and wherein in the case of a worn gas injector (1) the opening duration of the gas injector (1) is adjusted by the control to the required amount of gas and in the case of a defective gas injector the ignition of the combustion engine is deactivated by the control.

11. An internal combustion engine comprising an engine control (4), a source for gaseous fuel, at least one combustion chamber in which the gaseous fuel is ignited and an electromagnetically actuated gas injector (1) arranged between the source for the gaseous fuel and the at least one combustion chamber, **characterised in that** at at least one moment in time at which the gas injector (1) should be in a closed end position the engine control (4) applies an electric test voltage to the gas injector (1), measures the discharge current (I) caused by the electric test voltage and thus draws a conclusion about the existence of the closed end position of the gas injector (1).

## Revendications

1. Procédé pour vérifier si une soupape d'injection de gaz (1) actionnée par voie électromagnétique, agencée dans un moteur à combustion interne entre une source de carburant et un espace de combustion se trouve dans sa position finale fermée, contenant une alimentation de la soupape d'injection de gaz (1) en une tension électrique test et une mesure du courant de décharge (I) provoqué par la tension électrique test.

2. Procédé selon la revendication 1, la tension électrique test étant appliquée dans le laps de temps entre un moment de fermeture de soupape prescrit et un moment d'allumage prévu.

3. Procédé selon la revendication 1 ou 2, la tension électrique test étant appliquée sous la forme d'une impulsion de tension continue avec une durée prédéterminée et/ou une amplitude prédéterminée.

4. Procédé selon la revendication 1 ou 2, la tension électrique test étant appliquée sous la forme d'une tension alternative avec une durée prédéterminée et/ou une amplitude prédéterminée.

5. Procédé selon l'une quelconque des revendications 1 à 4, le gradient du courant de décharge (I) étant déterminé dans un intervalle de temps prédéterminé.

6. Procédé selon l'une quelconque des revendications 1 à 4, la valeur absolue du courant de décharge (I) étant déterminée à au moins un moment.

7. Procédé selon l'une quelconque des revendications 1 à 4, une intégrale du courant de décharge (I) étant déterminée sur un intervalle de temps prédéterminé.

8. Procédé selon l'une quelconque des revendications 1 à 4, l'inductance ou l'impédance de la bobine de soupape étant déterminée à partir du courant de décharge.

9. Procédé selon l'une quelconque des revendications 1 à 8, l'alimentation en tension électrique test étant réalisée au moins deux fois pour la détermination du moment de l'atteinte et/ou du temps nécessaire jusqu'à l'atteinte de la position finale fermée de la soupape d'injection de gaz (1).

10. Procédé selon la revendication 9, une commande du moteur à combustion interne faisant la différence en fonction du moment déterminé ou du temps nécessaire entre une soupape d'injection de gaz (1) usée et une soupape d'injection de gaz (1) défectueuse et la durée d'ouverture de la soupape d'injection de gaz (1) étant réglée sur la quantité de gaz nécessaire par la commande en cas de soupape d'injection de gaz (1) usée et l'allumage de l'espace de combustion étant désactivé en cas de soupape d'injection de gaz défectueuse.

11. Moteur à combustion interne avec une commande de moteur (4), une source de carburant gazeux, au moins un espace de combustion, dans lequel le carburant gazeux est allumé et une soupape d'injection de gaz (1) actionnée par voie électromagnétique, agencée entre la source pour le carburant gazeux et l'au moins un espace de combustion, **caractérisé en ce que** la commande de moteur (4) applique à au moins un moment, auquel la soupape d'injection de gaz (1) devrait se trouver dans une position finale fermée, une tension électrique test à la soupape d'injection de gaz (1), mesure le courant de décharge (I) provoqué par la tension électrique test et en déduit ainsi la présence de la position finale fermée de la soupape d'injection de gaz (1).
